# EUROPÄISCHE PATENTANMELDUNG

(11) **EP 0 546 252 A1**
(43) Veröffentlichungstag der Anmeldung: **16.06.1993**
(21) Anmeldenummer: 92112323.8
(22) Anmeldetag: 18.07.1992
(51) Int. Cl.: G01R 29/08

(54) **Messvorrichtung zum wegabhängigen Messen elektrischer Grössen**

(30) Priorität: 10.12.1991 DE 4140634
(71) Anmelder: ROBERT BOSCH GMBH, 70442 Stuttgart (DE)
(72) Erfinder: Widmann, Friedrich, Dipl. Ing., W-1000 Berlin 21 (DE)

(57) **Zusammenfassung**

2.1 Mit der erfindungsgemäßen Meßvorrichtung soll erreicht werden, daß elektrische Größen in einem Fahrzeug in Abhängigkeit vom zurückgelegten Weg gemessen werden können ohne jeglichen Eingriff in die Karosserie des Fahrzeuges.

2.2 Die Lösung der gestellten Aufgabe besteht darin, daß mit einem zu dem Fahrzeug (10) gehörenden Generator (11), der unter anderem für die Stromversorgung in dem Fahrzeug dient, eine Signalaufbereitungsschaltung (20) verbunden die eine pulsförmige Spannung (Up) liefert. Diese Spannung wird einem Meßgerät (27) als Wegbasis zugeführt. 3. In der Figur ist ein Blockschaltbild der kompletten Meßvorrichtung gezeigt.

## Beschreibung

Die Erfindung geht von einer Meßvorrichtung nach dem Oberbegriff des Anspruchs 1 aus.

Es ist schon eine Drehzahl- und Kilometer-Meßvorrichtung bei Fahrzeugen bekannt. Diese setzt die Installation eines mit einem Rad verbundenen Tachometergenerators voraus. Darüber hinaus muß im Betrieb mit einer Abnutzung der beweglichen Teile des Tachometergenerators gerechnet werden, so daß in regelmäßigen Abständen eine Wartung erforderlich ist.

Der Erfindung liegt die Aufgabe zugrunde, eine Meßvorrichtung gemäß dem Oberbegriff des Anspruchs 1 derart zu vereinfachen, daß kein zusätzlicher Tachometergenerator und kein Eingriff in die Karosserie des Fahrzeuges erforderlich sind.

Diese Aufgabe wird durch die in dem Anspruch 1 angegebenen Merkmale gelöst. Damit ist der Vorteil verbunden, daß auf einen zusätzlichen Tachometergenerator verzichtet werden kann und daß an der Karosserie keine Veränderungen vorgenommen werden müssen. Eine bevorzugte Anwendung für die Meßvorrichtung ist die meßtechnische Ermittlung der Empfangsfeldstärke eines Funkempfängers in einem sich entlang einer Fahrstrecke bewegenden Eisenbahnwagens.

Ein Ausführungsbeispiel der Erfindung ist in der Zeichnung an Hand zweier Figuren dargestellt und wird im folgenden näher beschrieben. Es zeigen
Fig. 1 eine Ansicht eines Eisenbahnwagens mit einem Generator und
Fig. 2 ein Blockschaltbild der erfindungsgemäßen Meßvorrichtung.

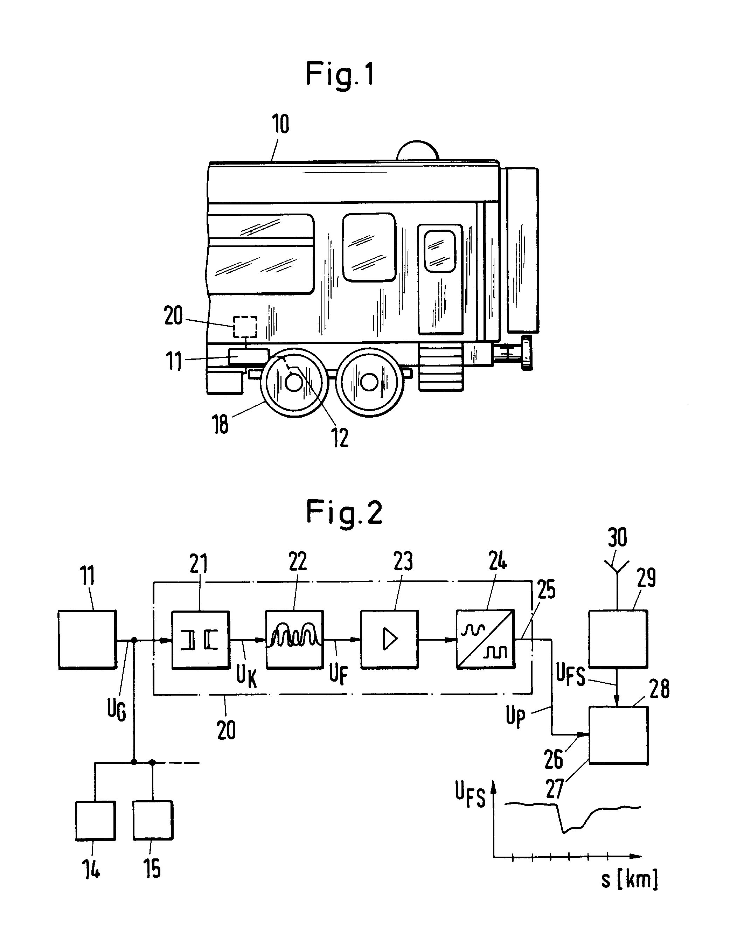

In Fig. 1 trägt ein Eisenbahnwagen 10 an seiner Unterseite einen Generator 11, der zum Beispiel über ein Getriebe 12 mit einem Rad 13 des Eisenbahnwagens verbunden ist. Der Generator 11 liefert den Strom für verschiedene in dem Eisenbahnwagen 10 vorhandene elektrische Verbraucher, von denen in Fig. 2 als Beispiele nur eine elektrische Beleuchtung 14 und eine Kommunikationseinrichtung 15 gezeigt sind. An den Generator 11 ist weiterhin eine in dem Eisenbahnwagen 10 enthaltene Signalaufbereitungsschaltung 20 angeschlossen (vgl. Fig. 2), die eine Signalabtrennschaltung 21, ein Filter 22, einen Signalverstärker 23 und einen Pulsformer 24 umfaßt. An einen Eingang 25 der Signalaufbereitungsschaltung20 schließt sich ein erster Eingang 26 eines Meßgerätes 27, das ist zum Beispiel ein Plotter, an. Ein zweiter Eingang 28 des Meßgerätes ist mit einem Ausgang eines Funkempfängers 29 verbunden, dessen Antenne mit 30 bezeichnet ist.

Die Wirkungsweise der Meßvorrichtung nach Fig. 2 ist folgende. Bei fahrendem Eisenbahnwagen 10 liefert der Generator 11 eine Generatorspannung Uα, die den Verbrauchern 14 und 15 und der Signalaufbereitungsschaltung 20 zugeführt wird. Mit der Signalabtrennschaltung 21, das ist vorzugsweise ein Übertrager, wird von der Generatorspannung U_{G} eine Wechselspannung U_{K} ausgekoppelt, von der das Filter 22 nur eine bestimmte Wechselspannungskomponente U_{F} durchläßt. Nach einer gegebenenfalls notwendigen Verstärkung der Wechselspannung U_{F} durch den Verstärker 23 findet in dem Pulsformer 24 eine Umwandlung der zum Beispiel sinusförmigen Wechselspannung in eine Pulsspannung Up, das heißt in eine zum Beispiel rechteckförmige Impulsfolge, statt. Die Summe der Impulse der am ersten Eingang 26 des Meßgerätes 27 liegenden Pulsspannung Up ist ein Maß für den von dem Eisenbahnwagen 10 zurückgelegten Weg s. Der zweite Eingang 28 des Meßgerätes erhält eine der Feldstärke des mit der Antenne 30 des Funkempfängers empfangenen Hochfrequenzsignals proportionale Spannung U_{Fs}. Während der Fahrt kann somit laufend die Feldstärke U_{FS} in Abhängigkeit von dem zurückgelegten Weg s des Eisenbahnwagens 10 gemessen und registriert werden; vgl. Diagramm unterhalb des Plotters 27 in Fig. 2.

## Patentansprüche

1. Meßvorrichtung zum wegabhängigen Messen von elektrischen Größen in einem sich bewegenden Fahrzeug, das einen Generator zur Stromversorgung von in dem Fahrzeug angeordneten elektrischen Verbrauchern enthält, dadurch gekennzeichnet, daß die Meßvorrichtung eine an den Generator (11) angeschlossene Signalaufbereitungsschaltung (20) zum Erzeugen einer dem vom Fahrzeug (10) zurückgelegten Weg (s) proportionalen pulsförmigen Spannung (Up) aufweist.

2. Meßvorrichtung nach Anspruch 1, dadurch gekennzeichnet, daß die Signalaufbereitungsschaltung (20) aus einer Signalabtrennschaltung (21), einem Filter (22) und einem Pulsformer (24) besteht, dessen Ausgang (25) mit einem ersten Eingang (26) eines elektrischen Meßgerätes (27) verbunden dessen zweiter Eingang (28) mit einer die zu messende elektrische Größe abgebenden Signalquelle (29) verbunden ist.

3. Meßvorrichtung nach Anspruch 2, dadurch gekennzeichnet, daß das elektrische Meßgerät (27) ein Plotter ist.

4. Meßvorrichtung nach einem der Ansprüche 1 bis 3, dadurch gekennzeichnet, daß die die elektrische Größe abgebende Signalquelle ein Funkempfänger (29) und daß die elektrische Größe die Empfangsfeldstärke des Funkempfängers ist.
